# EUROPEAN PATENT SPECIFICATION

(11) **EP 0 373 504 B1**
(45) Date of publication and mention of the grant of the patent: **06.04.1994**
(21) Application number: 89122557.5
(22) Date of filing: 07.12.1989
(51) Int. Cl.: G21K 1/04, G21K 5/00, H05H 7/00

(54) **Synchrotron radiation irradiation equipment**
Synchrotron-Bestrahlungsgerät
Dispositif d'irradiation par radiation de synchrotron

(30) Priority: 08.12.1988 JP 310422/88
(43) Date of publication of application: 20.06.1990
(73) Proprietor: FUJITSU LIMITED, Kawasaki-shi, Kanagawa 211 (JP)
(72) Inventor: Yamashita, Yoshimi c/o FUJITSU LIMITED, Kawasaki-shi Kanagawa 211 (JP); Horiuchi, Kei c/o FUJITSU LIMITED, Kawasaki-shi Kanagawa 211 (JP)
(74) Representative: Sunderland, James Harry

(56) References cited:
- DE-A- 3 806 950
- NUCLEAR INSTRUMENTS AND METHODS IN PHYSICS RESEARCH, vol. 222, 1984, pages 345-346, Amsterdam, NL; R. TATCHYN et al.: "A UHV chopper design for SSRL"
- NUCLEAR INSTRUMENTS AND METHODS IN PHYSICS RESEARCH, vol. A-246, 1986, pages 41-44, Amsterdam, NL; E.S. GLUSKIN et al.: "First experiments with SR from the 75 KG superconducting wiggler on the VEPP-2M storage ring"

## Description

The present invention relates to irradiation equipment used for application of synchrotron radiation.

In recent years, the number of synchrotrons available for research and development has increased. Electrons accelerated and moving around a circular orbit in a ring-shaped synchrotron radiate so-called synchrotron radiation (abbreviated to SR) into a beam line. Irradiation equipment of the kind with which the present invention is concerned provides a system connected to or for connection to a main synchrotron body, receiving synchrotron radiation at one end and irradiating it into a work chamber at the other end. The equipment is associated with beam ducts, a work chamber, exhaust systems, valves, aperture plates, etc.

Synchrotron radiation has attracted considerable attention in the field of lithography technology, semiconductor process technology, etc. However, synchrotron radiation is irradiated from a synchrotron operating at a high vacuum, higher than 10⁻⁷ to 10⁻⁸ Pa (10⁻⁹ to 10⁻¹⁰ Torr), and therefore, irradiation equipment is required to have a high vacuum at an inlet side thereof. Moreover, the equipment may be connected or coupled to a work chamber operating with a low degree of vacuum or at an atmospheric pressure (a pressure of the order of atmospheric pressure). In one case, a beryllium window is sealed over a beam duct at an end thereof through which synchrotron radiation is irradiated into a work chamber. In another case, the work chamber is directly connected to the end of the beam duct without the beryllium window. In the former case, the pressure of the work chamber is arbitrarily determined depending on the intended application of the synchrotron radiation and usually can be in a range from atmospheric pressures to a low vacuum of 10 to 1 Pa (10⁻¹ to 10⁻² Torr). In the latter case, the pressure of the work chamber in which a subject for irradiation is disposed is determined in consideration of overall exhaust capacity of the irradiation equipment. In this case, the work chamber is generally kept at pressures of about 10⁻⁴ to 10⁻⁵ Pa (10⁻⁶ to 10⁻⁷ Torr).

In previous proposals, a plurality of vacuum systems connected in cascade and forming a differential exhaust system are utilised in order to connect the irradiation equipment to the synchrotron, in which electrons are moving at a high speed, close to light speed. Each vacuum system comprises a beam duct, exhaust pump, gate valve, aperture plate, etc.

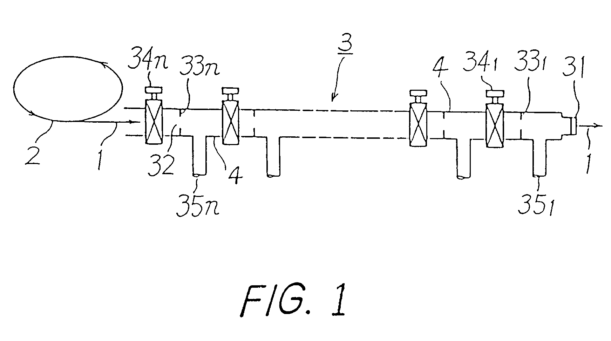

Fig. 1 illustrates schematically the structure of previously proposed synchrotron radiation irradiation equipment.

In Fig. 1, a synchrotron radiation beam 1 is injected into an inlet of a beam line 3 from a synchrotron 2. The synchrotron radiation beam 1 progresses along the beam line 3 and is output from a beryllium (Be) window 31 sealed at an outlet end of the beam line 3. In this case, a subject to be irradiated by synchrotron radiation, and a work chamber, is disposed beyond or outside the Be window, and therefore at an atmospheric pressure.

The beam line 3, which constitutes a main part of irradiation equipment employing synchrotron radiation, comprises a plurality of vacuum systems, each comprising an aperture plate 33 (33₁ to 33ₙ) having a beam transmission hole 32 at its centre, a gate valve 34 (34₁ to 34ₙ), an exhaust duct 35 (35₁ to 35ₙ), pumps (not shown), etc., forming a differential exhaust system.

The beam line 3 comprising the above vacuum systems has the function not only of transmitting the synchrotron radiation beam 1 but also that of suppressing flow of gas molecules from a low-vacuum side towards a high-vacuum side of the line. The Be plate 31 sealed at the end of the beam line 3 is required to have a high transmissivity for the synchrotron radiation beam and to have superior mechanical strength.

However, previously proposed synchrotron radiation irradiation equipment has suffered the following problems. The aperture plates 33 dividing the beam line 3 into a plurality of sections and preventing gas molecules from moving towards a high-vacuum side of the line, have beam transmission holes 32. The beam transmission holes 32 form a bypass for the differential exhaust system, resulting in reduction of overall exhaust efficiency. Even when the end portion of the beam line 3 sealed by the Be window is evacuated down to pressures of about 10⁻⁴ to 10⁻⁵ Pa (10⁻⁶ to 10⁻⁷ Torr), the total length of the differential exhaust system is more than 10 meters.

When a synchrotron radiation beam with a wavelength range comprehending a few Angstroms to several tens of Angstroms is required, attenuation in the Be plate cannot be ignored. The above-mentioned wavelength range is widely used in semiconductor lithography processes. In order to reduce attenuation therein, the thickness of the Be plate is preferably reduced to less than 50 microns. However, a Be plate less than 50 microns thick cannot withstand the pressure difference between the atmospheric pressure of the work chamber and 10⁻⁴ to 10⁻⁵ Pa (10⁻⁶ to 10⁻⁷ Torr) at the end portion of the irradiation equipment.

When utilising synchrotron radiation with wavelengths much longer than several tens of Angstroms, the attenuation of a Be plate is so high that such a Be plate cannot be used, and the work chamber should be directly coupled to the beam line, the pressure therein being kept at a vacuum of 10⁻⁴ to 10⁻⁵ Pa (10⁻⁶ to 10⁻⁷ Torr). Therefore, the subject of irradiation in the work chamber cannot easily be handled or manipulated.

The textbook "Handbook on Synchrotron Radiation" by E. E. Koch, North-Holland Publishing Co., Amsterdam, 1983, discloses synchrotron radiation equipment having the features of the preamble of accompanying claim 1, as discussed above with reference to Fig. 1.

According to the present invention, there is provided irradiation equipment, for providing irradiation by synchrotron radiation when one end of the equipment is coupled to a synchrotron, a work chamber is disposed at the other end of the equipment, and a synchrotron radiation beam is transmitted through the equipment, the irradiation equipment comprising a beam duct disposed along a path for the synchrotron radiation beam; and characterised by:-
a multistage axial flow turbine installed in the beam duct, the multistage axial flow turbine comprising a plurality of stators and rotors arranged alternately in an axial direction of the turbine, each stator having vanes and a beam transmission hole formed in its vane region, and each rotor having vanes and gaps between adjacent vanes, a plurality of such beam transmission holes being aligned in a direction of said synchrotron radiation beam, and a plurality of such gaps being in positions aligned in the axial direction of the turbine, whereby the synchrotron radiation beam can penetrate through the beam transmission holes and gaps of the multistage axial flow turbine intermittently, with rotation of the rotors.

An embodiment of the present invention can provide synchrotron radiation irradiation equipment which provides separation of a work chamber from the irradiation equipment, without employment of a Be plate.

An embodiment of the present invention can provide synchrotron radiation irradiation equipment in which the provision of a substantial number of vacuum systems, as in previous proposals, is avoided and the length of the irradiation equipment is reduced.

An embodiment of the present invention can provide synchrotron radiation irradiation equipment in which a synchrotron radiation beam can be effectively utilised regardless of its wavelength.

An embodiment of the present invention can provide synchrotron radiation irradiation equipment which is easily handled.

Irradiation equipment in accordance with an embodiment of the present invention is intended to be coupled to a synchrotron at one end and to be arranged along the beam line of synchrotron radiation. The irradiation equipment comprises a multistage axial flow turbine arranged in the beam duct, the multistage axial flow turbine having an inlet and outlet for a synchrotron radiation beam located apart from a central axis of the turbine and having a plurality of stators and rotors, each stator and rotor having vanes and being arranged alternately in the axial direction of the turbine, each stator having a hole formed in the vane region and the plurality of holes of the stators being aligned in the axial direction, and each rotor having gaps between the vanes and the gap positions of the rotors being aligned in the axial direction, thereby enabling the synchrotron radiation beam to penetrate from the inlet to the outlet of the axial flow turbine via the holes and gaps with rotation of the rotor.

Reference is made, by way of example, to the accompanying drawings, in which:-
Fig. 1 is a schematic diagram of previously proposed irradiation equipment,
Fig. 2(a) shows a schematic skeleton diagram for assistance in explaining basic structure of irradiation equipment in accordance with an embodiment of the present invention,
Fig. 2(b) is a partial cross-sectional view of vanes of stators and rotors of a multistage axial flow turbine of an embodiment of the present invention,
Fig. 3 is a schematic cross-sectional illustration of a multistage axial flow turbine of an embodiment of the present invention,
Fig. 4 gives a plan view (a) and a schematic side view (b) of a stator of a multistage axial flow turbine of an embodiment of the present invention,
Fig. 5 gives a plan view (a) and a schematic side view (b) of a rotor of the multistage axial flow turbine,
Fig. 6 is a block diagram of a control unit of an embodiment of the present invention,
Fig. 7 is a schematic diagram of irradiation equipment embodying the present invention,
Fig. 8 is a schematic diagram of irradiation equipment embodying the present invention, and
Fig. 9 is a schematic diagram of irradiation equipment embodying the present invention.

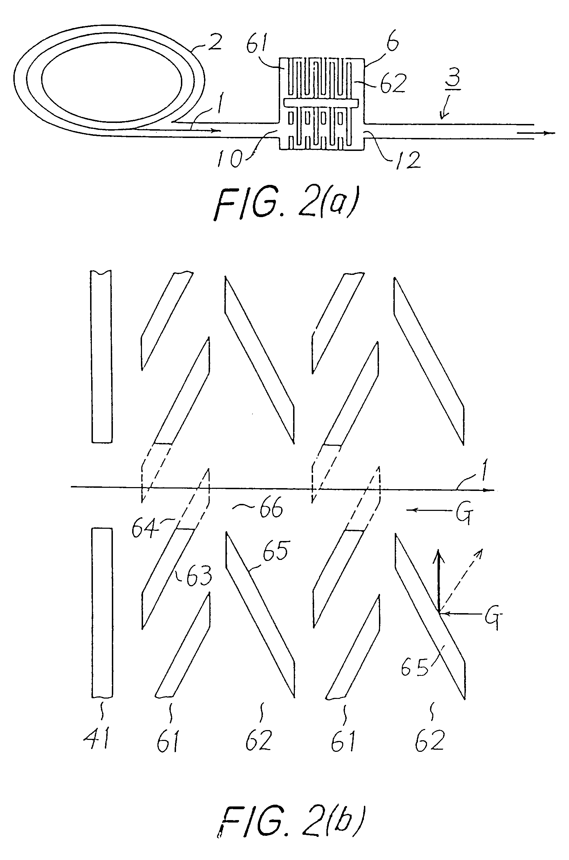

A schematic skeleton or outline diagram for assistance in explaining the structure of irradiation equipment in accordance with an embodiment of the present invention is shown in Fig. 2(a). The equipment comprises a multistage axial flow turbine 6 provided along a beam line 3.

A synchrotron 2 (in other words, an electron acceleration and storage ring), which is depicted by a ring-shape, accelerates electrons around a circular orbit. The accelerated electrons at a high speed, close to light speed, radiate synchrotron radiation, which advances along beam line 3. On the way toward a work chamber (not shown), the multistage axial turbine 6 is provided and has an inlet 10 and an outlet 12, in a casing of the multistage axial flow turbine 6, their positions being apart from a centre axis of the axial flow turbine 6. The multistage axial flow turbine 6 may be called a turbomolecular pump or turbo pump.

The multistage axial flow turbine 6 comprises a plurality of stators 61 and rotors 62. In the multistage axial flow turbine of this embodiment of the present invention, a stator 61 has a beam transmission hole and a rotor 62 has a gap between adjacent vanes thereof. When these beam transmission holes and gaps are aligned in a line, parallel to the centre axis and coincident with a line connecting the inlet 10 to the outlet 12, synchrotron radiation beam 1 penetrates through the beam line 3 and can be utilised for many irradiation applications.

The stators 61 and rotors 62 are arranged alternately in the axial direction, and the centres of the rotors 62 are fixed to a rotatable axis of the axial flow turbine 6. Fig. 2(b) is a partial cross-sectional illustration of vanes of stators 61 and rotors 62. Beam transmission holes 64 are formed in vanes 63 of stators 61 and gaps 66 are formed between pairs of adjacent vanes 65 of rotors 62. When a plurality of beam transmission holes 64 and gaps 66 are aligned in line with the rotation of the rotor 62, synchrotron radiation beam 1 penetrates through the multistage axial flow turbine 6.

In Fig. 2(b), a residual gas molecule G, moving from a low-vacuum side towards a higher vacuum side, impinges on a vane 65 of the rotor 62 as shown by a solid arrowed line. Because the vane 65 is moving at high speed in a direction perpendicular to the plane of the Figure, as indicated by a bold solid arrow, the residual gas molecule G is repelled back toward the low-vacuum side as indicated by a broken arrowed line and inflow of gas molecules towards the high-vacuum side is prevented. Though some proportion of the gas molecules flow toward the high-vacuum side through gaps 66 between rotor vanes 65, most of the molecules are pushed back towards the low-vacuum side, because a plurality of rotors 62 are provided in the axial direction and even when a molecule has passed through one gap it is likely subsequently to encounter another rotor.

In contrast to the differential exhaust system of previous proposals, the multistage axial flow turbine 6 can be installed in a narrow restricted space. Further, of itself, it fulfils the functions of a multistage exhaust system, because a single stator 61 and rotor 62 pair constitutes a single exhaust system stage. Therefore, a sufficiently high vacuum can be maintained in the synchrotron 2 by the increased number of exhaust stages provided by the multistage axial flow turbine 6. Even when the output of the axial flow turbine is connected to a work chamber, which is disposed at the lower vacuum side and kept at an atmospheric pressure or at a degree of vacuum of 10 to 1 Pa (10⁻¹ to 10⁻² Torr), a sufficiently high vacuum can be obtained at the high-vacuum side of the multistage axial flow turbine 6.

Because the velocities of the moving gas molecules do not exceed the velocity of sound, there is a large difference between their velocities and the velocity of synchrotron radiation (which latter is close to light velocity). Even when the rotors 62 are rotated at such a high speed that residual gas molecules colliding with the rotating vanes 65 thereof are repelled backward, the synchrotron radiation beam is not interrupted completely due to collision with vanes 65. In this case, the synchrotron radiation beam 1 is, in effect, switched on and off by the vanes 65 of the rotors 62; however, the availability of only intermittently penetrating synchrotron radiation causes no problem in practical applications.

The multistage axial flow turbine utilised in the irradiation equipment of the embodiment of the present invention has a similar structure to that utilised as a vacuum pump except that it has the additional structural features providing for transmission of the synchrotron radiation beam therethrough.

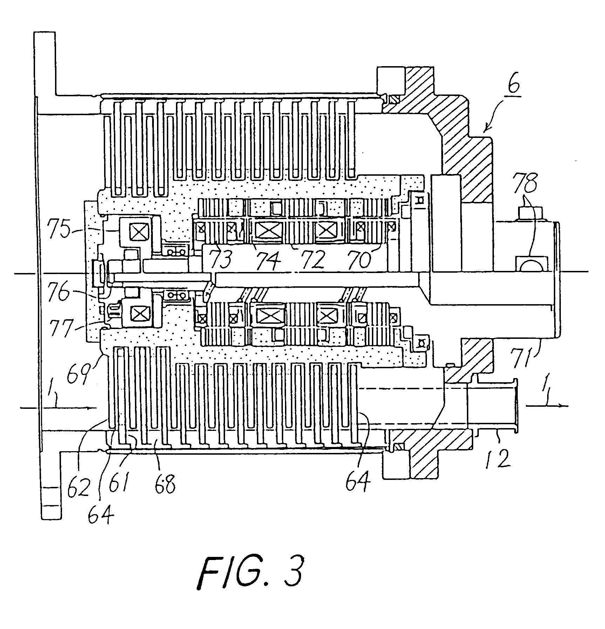

The multistage axial flow turbine 6 of an embodiment of the present invention is shown in Fig. 3.

Pluralities of stators 61 and rotors 62 are provided and arranged alternately in an axial direction of the turbine, each of the stators and rotors having a plurality of vanes, stators 61 being fixed to an outer casing 68 at an outer periphery of the turbine, and rotors 62 being fixed to a rotating axis 69 at an inner periphery of the turbine. The rotating axis 69 is supported rotatably on a stationary fixed axis 71 via magnetic bearings 70 and 73, and a high-frequency motor 72 is provided between the rotating axis 69 and fixed axis 71.

In the device, wherein the rotating axis 69 is supported on the stationary fixed axis 71 via magnetic bearings 70 and 73, and the high-frequency motor 72 is provided between the rotating axis 69 and fixed axis 71, a mechanism is necessary for maintaining correct relative positioning as between the rotating axis and the fixed axis. A radial position sensor 74 detects the relative radial position of the rotating axis 69 and an axial position sensor 76 detects the relative axial position thereof, both sensors being disposed on the fixed axis 71, providing for maintenance of correct positioning as between the rotating axis 69 and fixed axis 71.

A position detection sensor 77 outputs a signal synchronous with rotor rotation, and connectors 78 function to supply electric power to the magnetic bearings 70, 73 and high-frequency motor 72, and further function to pick up signals from the axial position sensor 76 and position detection sensor 77.

An outlet 12 for synchrotron radiation is provided on the outer casing 68 of the multistage axial flow turbine 6, and a beam transmission hole 64 is formed in stator vanes at a radial position corresponding to the synchrotron radiation outlet 12. Therefore, the synchrotron radiation beam 1, input from the high-vacuum side to the multistage axial flow turbine 6, penetrates through the gaps between rotor vanes and the stator beam transmission holes, and is output from the synchrotron radiation outlet 12.

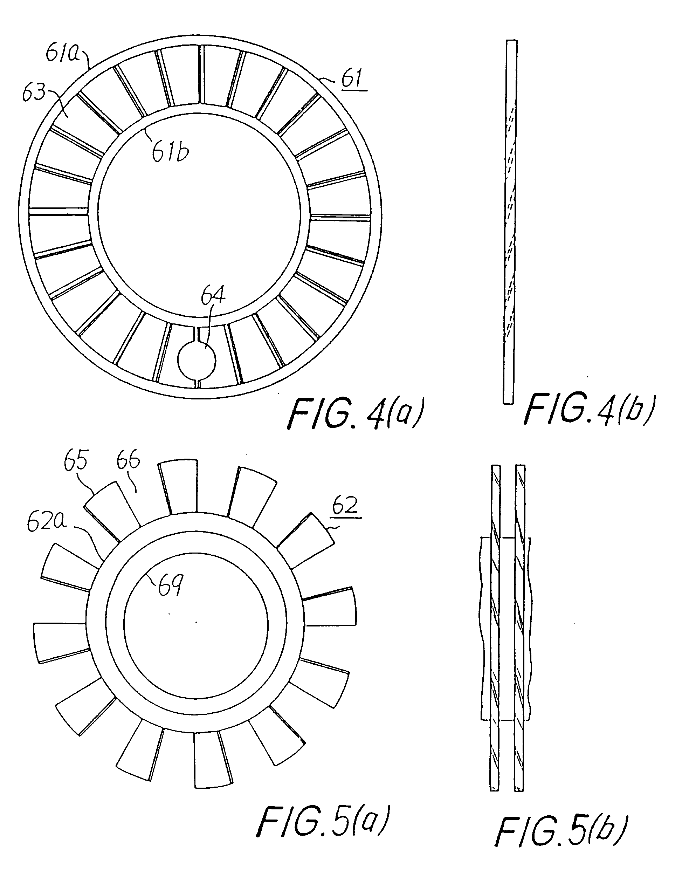

As shown in Fig. 4(a), a stator 61 comprises an outer ring 61a, an inner ring 61b and a plurality of vanes 63. The surface of each vane 63, fixed between outer ring 61a and inner ring 61b, has an inclination in a circumferential direction having a predetermined angle with regard to the plane of Fig. 4(a). The inclination of vanes 63 along the circumferential direction is shown schematically in Fig. 4(b). A beam transmission hole 64 is formed in the vane region by cutting away a portion of two vanes 63.

As shown in Fig. 5(a), a rotor 62 comprises a plurality of vanes 65 fixed to an inner ring 62a at one end, and a plurality of inner rings 62a having vanes are integrated with the rotating axis 69 as one body. The surface of each vane fixed to the inner ring 62a has also an inclination of a predetermined angle to a direction of vane rotation, which is shown schematically in a similar way in Fig. 5(b), and a plurality of gaps 66 between vanes 65 are provided around the inner ring 62a for transmission of the synchrotron radiation beam.

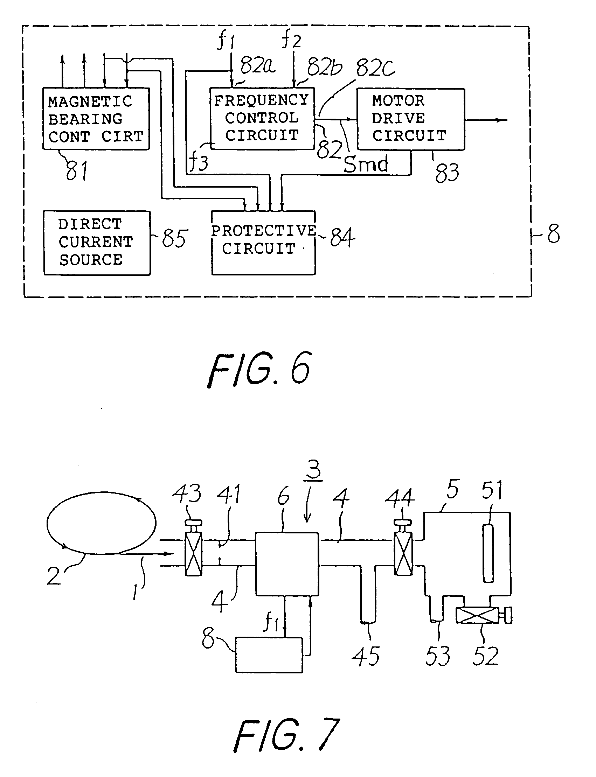

A control unit 8 is provided for driving the multistage axial flow turbine, and a block diagram of this unit is given in Fig. 6. The control unit 8 comprises a magnetic bearing control circuit 81, a frequency control circuit 82, a motor drive circuit 83, a protective circuit 84 and a direct current source 85. The magnetic bearing control circuit 81 controls currents applied to the magnetic bearings 70 and 73 and axial magnet 75, the currents being controlled by the signals from the radial position sensor 74 and axial position sensor 76 such that the rotating axis 69 rotates stably at a predetermined position.

The frequency control circuit 82 comprises a signal generator circuit (not shown) and provides a first signal input terminal 82a, a second signal input terminal 82b and a signal output terminal 82c. A feedback signal f₁, input to the first signal input terminal 82a from the position detection sensor 77, is compared with either another input signal f₂ from the second signal input terminal 82b or a control signal f₃ from the signal generator circuit, resulting in the output of a signal Smd from a signal output terminal 82c, and the signal Smd controls the speed of the multistage axial flow turbine driven by the motor drive circuit 83.

For example, while the multistage axial flow turbine 6 is rotating stably at a predetermined speed during operation, the control signal f₃ of a predetermined frequency is directly output from the signal output terminal 82c. When there is a difference between the feedback signal f₁ and control signal f₃, the signal Smd is output, which will either accelerate or decelerate the rotation of the multistage axial flow turbine such that the difference will diminish. When starting the multistage axial flow turbine, the signal f₃ is much larger than the signal f₁ and an acceleration signal Smd such as would diminish the frequency difference is output from the signal output terminal 82c. When stopping the motor, a deceleration signal Smd such as would increase the frequency difference is output.

Further, the motor drive circuit 83 supplies driving current to the high-frequency motor 72 of the multistage axial flow turbine, the driving current being controlled by the signal Smd input from the frequency control circuit 82. The protective circuit 84 has the function of monitoring signals from radial direction sensor 74, axial direction sensor 76 and position detection sensor 77, and further monitoring load condition of the motor drive circuit 83. The direction current source 85 supplies electric current necessary for these circuits (detailed connections are omitted in Fig. 6).

A first example of application of the multistage axial flow turbine 6 to irradiation equipment in accordance with an embodiment of the present invention is shown in Fig. 7. Synchrotron radiation beam 1 from synchrotron 2 is input to the inlet (left in the Figure) side of the irradiation equipment, and is applied to a work chamber 5 provided on the outlet (right) side thereof, where a target 51 for irradiation is disposed. The irradiation equipment further comprises beam ducts 4, which form a main vacuum path of beam line 3, and multistage axial flow turbine 6 between two beam ducts 4. It further comprises a gate valve 43 and aperture plate 41 on the high-vacuum side, and a gate valve 44, an exhaust duct 45 and work chamber 5 having a gate valve 52 and an exhaust duct 53 on the low-vacuum side thereof. There is no Be plate such as is provided in the prior art along the path of the synchrotron radiation beam 1. The degree of vacuum in the work chamber 5 is maintained at about 10 to 1 Pa (10⁻¹ to 10⁻² Torr) by the gate valve 52 and an exhaust system connected to the exhaust duct 53.

In operation of the first example, while an exhaust pump (not shown) connected to the exhaust duct 45 is operated and the gate valves 43 and 44 are open, the multistage axial flow turbine 6 is driven, with the result that a satisfactory high vacuum for the synchrotron 2 is obtained. The multistage axial flow turbine 6 is driven by a high-frequency drive current output from the control unit 8. When there is a difference between a feedback signal f₁ and a control signal f₃, rotation of the multistage axial flow turbine is controlled such as to diminish the difference.

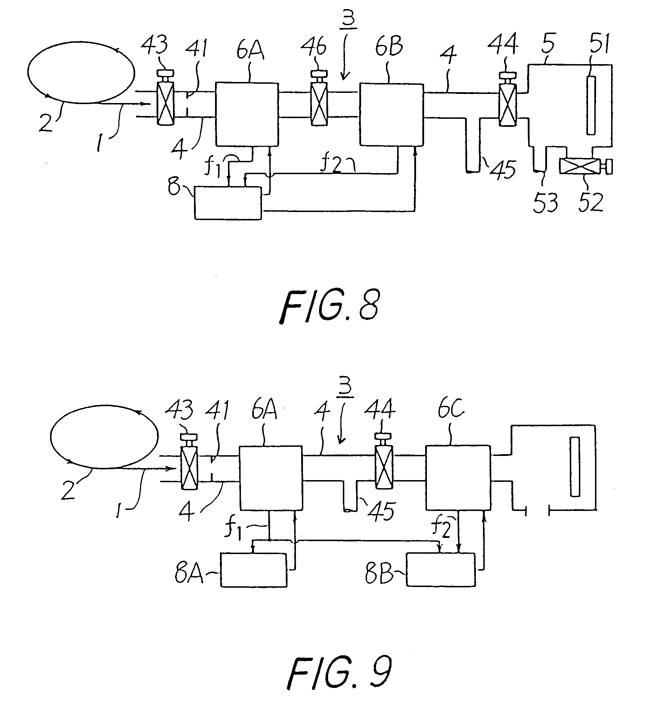

A second example of an embodiment of the present invention is shown in Fig. 8, where two multistage axial flow turbines 6A and 6B are installed along the beam line, other structures being substantially the same as in Fig. 7. On the high-vacuum side of the beam duct 4, gate valve 43 and aperture plate 41 are provided, and on the low-vacuum side thereof, a gate valve 44 connected to work chamber 5 and exhaust duct 45 are provided. A gate valve 46 is inserted between multistage axial flow turbines 6A and 6B. As in the case of the first example, there is no Be plate and the degree of vacuum in the work chamber 5, where a target for irradiation is disposed, is kept at about 10 to 1 Pa (10⁻¹ to 10⁻² Torr) by the gate valve 52 and exhaust duct 53.

In the second example, by opening gate valves 43 and 46, exhausting through exhaust duct 45 and driving two multistage axial flow turbines 6A and 6B, the vacuum in the synchrotron 2 can be brought to a higher degree than in the first example. In the second example, the positions of the gaps of the two groups of rotor vanes 65 for multistage axial flow turbines 6A and 6B are required to be arranged such that the relative gap positions of two groups are aligned at all times during operation, so the synchrotron radiation beam 1 can penetrate intermittently through the rotor gaps of two multistage axial flow turbines. Therefore, feedback signals f₁ and f₂ from two multistage axial flow turbines 6A and 6B are input to the first and second signal input terminals 82a and 82b respectively of the control unit 8 and, as a result, the multistage axial flow turbines 6A and 6B are controlled to rotate synchronously with each other, and the synchrotron radiation beam can penetrate intermittently through two multistage axial flow turbines 6A and 6B.

In the above explanation, the operations of two multistage axial flow turbine 6A and 6B are assumed to be synchronous with each other. However, the rotation speed of the first multistage axial flow turbine 6A, located on the high-vacuum side, can be made to be precisely twice or three times that of the second multistage axial flow turbine 6B located on the low-vacuum side, by suitable functioning of the control unit 8. When the ratio of the rotation speeds is an integer, the synchrotron radiation beam 1 can penetrate intermittently through two multistage axial flow turbines. Driving of two multistage axial flow turbines in this manner makes it possible to obtain a higher degree of vacuum at the high-vacuum side of the first multistage axial flow turbine 6A.

A third example of an embodiment of the present invention is shown in Fig. 9, in which two multistage axial flow turbines 6A and 6C are utilized and the work chamber is used at an atmospheric pressure. On the high-vacuum side of the beam duct 4, gate valve 43 and aperture plate 41 are provided, and gate valve 44 and exhaust duct 45 is provided between multistage axial flow turbines 6A and 6C. In the third example, by adjusting gate valves 43, and 44, exhausting through the exhaust duct 45 and driving two multistage axial flow turbines 6A and 6C, the vacuum in the synchrotron 2 connected to the beam duct 4 can be brought to a predetermined high vacuum degree. However, the low-vacuum side of the second multistage axial flow turbine 6C is directly exposed to the ambient atmosphere of the work chamber. In view of this, the number of rotors, and the size and shape of the vanes are different from those of the first multistage axial flow turbine 6A. As a result, it may be more difficult to obtain synchronism of gap positions for two groups of rotors such that two groups of gaps are aligned in a line.

In the third example, the first and second multistage axial flow turbines 6A and 6C are provided with control units 8A and 8B respectively, to which feedback signals f₁ and f₂, output from the multistage axial flow turbines 6A and 6C, are input respectively. At the same time, the feedback signal f₁ from the first multistage axial flow turbine 6A is also input to the control unit 8B, providing for the second multistage axial flow turbine 6C to be synchronised with the first multistage axial flow turbine 6A. In this example, the work chamber 5 is directly connected to the multistage axial flow turbine 6C, with no Be plate (which would be an attenuation factor for the synchrotron radiation beam 1).

In a manner similar to the second example, the rotation speed of the first multistage axial flow turbine 6A may be twice or three times that of the second multistage axial flow turbine 6C. When the rotation speed ratio is an integral number, the synchrotron radiation beam 1 can penetrate through two multistage axial flow turbines intermittently.

As described above, synchrotron radiation irradiation equipment embodying the present invention comprises a multistage axial flow turbine installed along a beam line. The multistage axial flow turbine has a plurality of stators and rotors, each having vanes and being arranged alternately in an axial direction of the turbine, and a beam transmission hole is formed in each stator vane region and a plurality of holes are aligned in an axial direction and the gaps are formed between adjacent vanes of the rotor and gap positions of a plurality of rotors are also aligned in the axial direction. When the beam transmission holes of the stator and the gaps of the rotors are aligned in the axial direction, the synchrotron radiation beam penetrates through the multistage axial flow turbine.

Exhaust efficiency of the irradiation equipment can be increased, and a target for irradiation can be placed in a work chamber at a low pressure of 10 to 1 Pa (10⁻¹ to 10⁻² Torr) or at an atmospheric pressure without use of a Be plate, and the length of the beam line can be reduced to less than 1 metre. Irradiation equipment which effectively outputs synchrotron radiation can be realised, regardless of the wavelength of the radiation. Irradiation equipment can be provided which has a short length beam line and affords easy handling.

The present invention provides synchrotron radiation irradiation equipment, which is coupled to a synchrotron at one end and to a work chamber at the other end thereof, and through which a synchrotron radiation beam is irradiated on to a target in the work chamber. The irradiation equipment comprises a beam duct disposed along the synchrotron radiation beam, and a multistage axial flow turbine installed in the beam duct. The multistage axial flow turbine comprises a plurality of stators and rotors arranged alternately in an axial direction, wherein each stator has vanes and a beam transmission hole formed in the vane region, and each rotor has vanes and gaps between adjacent vanes, and a plurality of beam transmission holes are aligned in a direction of the synchrotron radiation beam, and a plurality of gap positions of the rotors are aligned in the axial direction, whereby the synchrotron radiation beam can penetrate through the multistage axial flow turbine through the beam transmission holes and gaps intermittently with rotation of the rotor.

## Claims

1. Irradiation equipment, for providing irradiation by synchrotron radiation when one end of the equipment is coupled to a synchrotron (2), a work chamber (5) is disposed at the other end of the equipment, and a synchrotron radiation beam (1) is transmitted through the equipment, the irradiation equipment comprising a beam duct (3) disposed along a path for the synchrotron radiation beam (1); and characterised by:-
a multistage axial flow turbine (6) installed in the beam duct (3), the multistage axial flow turbine comprising a plurality of stators (61) and rotors (62) arranged alternately in an axial direction of the turbine (6), each stator (61) having vanes (63) and a beam transmission hole (64) formed in its vane region, and each rotor (62) having vanes (65) and gaps (66) between adjacent vanes, a plurality of such beam transmission holes (64) being aligned in the direction of said synchrotron radiation beam (1), and a plurality of such gaps being in positions aligned in the axial direction of the turbine (6), whereby the synchrotron radiation beam can penetrate through the beam transmission holes (64) and gaps (66) of the multistage axial flow turbine (6) intermittently, with rotation of the rotors (62).

2. Equipment as described in claim 1, further comprising a gate valve (43, 44, 46) and an aperture plate (41) installed in said beam duct (3) along said path for the beam (1).

3. Equipment as claimed in claim 2, wherein the gate valve (43) and the aperture plate (41) are arranged on a high-vacuum side of the multistage axial flow turbine (6), to which side the synchrotron (2) is to be coupled, the equipment further comprising an auxiliary exhaust system (45) connected to the beam duct (3) and another gate valve (44) installed in said beam duct along said path for the beam (1), on a low-vacuum side of the turbine, to which side the work chamber (5) is to be coupled.

4. Equipment as claimed in claim 1, comprising first (6A) and second (6B, 6C) such multistage axial flow turbines, a gate valve (43) and an aperture plate (41) installed in said beam duct (3) along said path for the beam (1), and an auxiliary exhaust system (45) connected to the beam duct (3), the alignments of beam transmission holes of the first and second multistage axial flow turbines (6A, 6B, 6C) being arranged to be coincident.

5. Equipment as claimed in claim 4, wherein the gate valve (43) and the aperture plate (41) are arranged on the high-vacuum side of the first multistage axial flow turbine (6A), to which side the synchrotron (2) is to be coupled, and the auxiliary exhaust system (45) and another gate valve (44) are arranged on the low-vacuum side of the second multistage axial flow turbine (6B), to which side the work chamber (5) is to be coupled, and a further gate valve (46) is arranged between the first and second multistage axial flow turbines.

6. Equipment as claimed in claim 4, wherein the gate valve (43) and the aperture plate (41) are arranged on the high-vacuum side of the first multistage axial flow turbine (6A), to which side the synchrotron (2) is to be coupled, the auxiliary exhaust system (45) and another gate valve (44) are arranged between the first and second multistage axial flow turbines (6A, 6C), and the low-vacuum side of the second multistage axial flow turbine (6C), to which side the work chamber (5) is to be coupled, is exposed to an atmospheric pressure.

7. Equipment as claimed in claim 4, 5 or 6, further comprising means (8) for controlling movements of the first and second multistage axial flow turbines (6A, 6B, 6C), the control means including circuit means (82, 83) for maintaining synchronism in rotation of said first and second multistage axial flow turbines.

8. Equipment as claimed in claim 4, 5 or 6, further comprising means (8) for controlling movements of the first and second multistage axial flow turbines (6A, 6B, 6C), the control means including circuit means (82, 83) for maintaining the rotation speed of the first multistage axial flow turbine (6A) at an integral number of times that of the second multistage axial flow turbine (6B, 6C).

## Patentansprüche

1. Einstrahlungseinrichtung, zum Vorsehen einer Einstrahlung durch Synchrotronstrahlung, wenn ein Ende der Einrichtung mit einem Synchrotron (2) verbunden ist, eine Arbeitskammer (5) an dem anderen Ende der Einrichtung angeordnet ist, und ein Synchrotronstrahl (1) durch die Einrichtung übertragen wird, welche Einstrahlungseinrichtung einen Strahlenkanal (3) umfaßt, der längs eines Weges für den Synchrotronstrahl (1) angeordnet ist; und gekennzeichnet durch:-
eine mehrstufige Axialturbine (6), die in dem Strahlenkanal (3) installiert ist, wobei die mehrstufige Axialturbine eine Vielzahl von Statoren (61) und Rotoren (62) umfaßt, die in einer axialen Richtung der Turbine (6) abwechselnd angeordnet sind, jeder Stator (61) Schaufeln (63) hat und ein Strahlübertragungsloch (64), das in seiner Schaufelzone gebildet ist, und jeder Rotor (62) Schaufeln (65) hat und Lücken (66) zwischen benachbarten Schaufeln, eine Vielzahl von solchen Strahlübertragungslöchern (64) in der Richtung des genannten Synchrotronstrahls (1) ausgerichtet sind, und eine Vielzahl von solchen Lücken an Positionen sind, die in der axialen Richtung der Turbine (6) ausgerichtet sind, wodurch der Synchrotronstrahl durch die Strahlübertragungslöcher (64) und Lücken (66) der mehrstufigen Axialturbine (6) bei Rotation der Rotoren (62) intermittierend hindurchtreten kann.

2. Einrichtung nach Anspruch 1, die ferner ein Schieberventil (43, 44, 46) und eine Aperturplatte (41) umfaßt, die in dem genannten Strahlenkanal (3) längs des genannten Weges für den Strahl (1) installiert sind.

3. Einrichtung nach Anspruch 2, bei der das Schieberventil (43) und die Aperturplatte (41) auf einer Hochvakuumseite der mehrstufigen Axialturbine (6) angeordnet sind, mit welcher Seite das Synchrotron (2) zu verbinden ist, welche Einrichtung ferner ein Zusatzabsaugsystem (45) umfaßt, das mit dem Strahlenkanal (3) verbunden ist, und ein anderes Schieberventil (44), die in dem genannten Strahlenkanal längs des genannten Weges für den Strahl (1) auf einer Niedervakuumseite der Turbine installiert sind, mit welcher Seite die Arbeitskammer (5) zu verbinden ist.

4. Einrichtung nach Anspruch 1, die erste (6A) und zweite (6B, 6C) solche mehrstufige Axialturbinen umfaßt, ein Schieberventil (43) und eine Aperturplatte (41), die in dem genannten Strahlenkanal (3) längs des genannten Weges für den Strahl (1) installiert sind, und ein Zusatzabsaugsystem (45), das mit dem Strahlenkanal (3) verbunden ist, wobei die Ausrichtungen von Strahlübertragungslöchern der ersten und zweiten mehrstufigen Axialturbinen (6A, 6B, 6C) angeordnet sind um übereinzustimmen.

5. Einrichtung nach Anspruch 4, bei der das Schieberventil (43) und die Aperturplatte (41) auf der Hochvakuumseite der ersten mehrstufigen Axialturbine (6A) angeordnet sind, mit welcher Seite das Synchrotron (2) zu verbinden ist, und das Zusatzabsaugsystem (45) und ein anderes Schieberventil (44) auf der Niedervakuumseite der zweiten mehrstufigen Axialturbine (6B) angeordnet sind, mit welcher Seite die Arbeitskammer (5) zu verbinden ist, und ein weiteres Schieberventil (46) zwischen den ersten und zweiten mehrstufigen Axialturbinen angeordnet ist.

6. Einrichtung nach Anspruch 4, bei der das Schieberventil (43) und die Aperturplatte (41) auf der Hochvakuumseite der ersten mehrstufigen Axialturbine (6A) angeordnet sind, mit welcher Seite das Synchrotron (2) zu verbinden ist, das Zusatzabsaugsystem (45) und ein anderes Schieberventil (44) zwischen den ersten und zweiten mehrstufigen Axialturbinen (6A, 6C) angeordnet sind, und die Niedervakuumseite der zweiten mehrstufigen Axialturbine (6C), mit welcher Seite die Arbeitskammer (5) zu verbinden ist, einem atmosphärischen Druck ausgesetzt ist.

7. Einrichtung nach Anspruch 4, 5 oder 6, die ferner ein Mittel (8) zum Steuern von Bewegungen der ersten und zweiten mehrstufigen Axialturbinen (6A, 6B, 6C) umfaßt, welches Steuermittel Schaltungsmittel (82, 83) enthält, zum Aufrechterhalten eines Synchronismus bei der Rotation der genannten ersten und zweiten mehrstufigen Axialturbinen.

8. Einrichtung nach Anspruch 4, 5 oder 6, die ferner ein Mittel (8) zum Steuern von Bewegungen der ersten und zweiten mehrstufigen Axialturbinen (6A, 6B, 6C) umfaßt, welches Steuermittel Schaltungsmittel (82, 83) enthält, zum Aufrechterhalten der Rotationsgeschwindigkeit der ersten mehrstufigen Axialturbine (6A) auf einem ganzzahligen Vielfachen von jener der zweiten mehrstufigen Axialturbine (6B, 6C).

## Revendications

1. Dispositif d'irradiation, pour procurer une irradiation par radiation de synchrotron, lorsqu'une extrémité du dispositif est couplée à un synchrotron (2), une chambre de travail (5) est disposée à l'autre extrémité du dispositif, et un faisceau de radiation de synchrotron (1) est transmis à travers le dispositif, le dispositif d'irradiation comprenant une canalisation de faisceau (3) disposée le long d'un chemin pour le faisceau de radiation de synchrotron (1) ; et caractérisé par : -
une turbine à écoulement axial à plusieurs étages (6) installée dans la canalisation de faisceau (3), la turbine à écoulement axial à plusieurs étages comprenant une pluralité de stators (61) et de rotors (62) agencés alternativement dans une direction axiale de la turbine (6), chaque stator (61) ayant des ailettes (63) et un trou de transmission de faisceau (64) formé dans sa région d'ailette, et chaque rotor (62) ayant des ailettes (65) et des interstices (66) entre des ailettes adjacentes, une pluralité de tels trous de transmission de faisceau (64) étant alignée dans une direction dudit faisceau de radiation de synchrotron (1), et une pluralité de tels interstices étant dans des positions alignées dans la direction axiale de la turbine (6), grâce à quoi, le faisceau de radiation de synchrotron peut pénétrer à travers les trous de transmission de faisceau (64) et les interstices (66) de la turbine à écoulement axial à plusieurs étages (6), de façon intermittente, avec rotation des rotors (62).

2. Dispositif comme décrit dans la revendication 1, comprenant de plus une vanne à obturateur (43, 44, 46), et un diaphragme (41) installés dans ladite canalisation de faisceau (3) le long dudit chemin pour le faisceau (1).

3. Dispositif comme revendiqué dans la revendication 2, dans lequel la vanne à obturateur (43) et le diaphragme (41) sont agencés sur un côté à vide élevé de la turbine à écoulement axial à plusieurs étages (6), auquel côté, le synchrotron (2) est à être couplé, le dispositif comprenant de plus un système pour faire le vide auxiliaire (45) relié au faisceau (3) et une autre vanne à obturateur (44) installée dans ladite canalisation de faisceau, le long dudit chemin pour le faisceau (1), sur un côté à faible vide de la turbine, auquel côté la chambre de travail (5) est à être couplée.

4. Dispositif comme revendiqué dans la revendication 1, comprenant de telles première (6A) et seconde (6B, 6C) turbines à écoulement axial à plusieurs étages, une vanne à obturateur (43) et un diaphragme (41) installés dans ladite canalisation de faisceau (3), le long dudit chemin pour le faisceau (1), et un système pour faire le vide auxiliaire (45) relié à la canalisation de faisceau (3), les alignements des trous de transmission de faisceau des première et seconde turbines à écoulement axial à plusieurs étages (6A, 6B, 6C) étant agencés afin d'être coïncidents.

5. Dispositif comme revendiqué dans la revendication 4, dans lequel la vanne à obturateur (43) et le diaphragme (41) sont agencés sur le côté à vide élevé de la première turbine à écoulement axial à plusieurs étages (6A), auquel côté le synchrotron (2) est à être couplé, et le système pour faire le vide auxiliaire (45) et une autre vanne à obturateur (44) sont agencés sur le côté à faible vide de la seconde turbine à écoulement axial à plusieurs étages (6B), auquel côté la chambre de travail (5) est à être couplée, et une autre vanne à obturateur (46) est agencée entre les première et seconde turbines à écoulement axial à plusieurs étages.

6. Dispositif comme revendiqué dans la revendication 4, dans lequel la vanne à obturateur (43) et le diaphragme (41) sont agencés sur le côté à vide élevé de la première turbine à écoulement axial à plusieurs étages (6A), auquel côté le synchrotron (2) est à être couplé, le système pour faire le vide auxiliaire (45) et une autre vanne à obturateur (44) sont agencés entre les première et seconde turbines à écoulement axial à plusieurs étages (6A, 6C), et le côté à faible vide de la seconde turbine à écoulement axial à plusieurs étages (6C), auquel côté la chambre de travail (5) est à être couplée, est exposé à une pression atmosphérique.

7. Dispositif comme revendiqué dans la revendication 4, la revendication 5 ou la revendication 6, comprenant de plus des moyens (8) pour commander des mouvements des première et seconde turbines à écoulement axial à plusieurs étages (6A, 6B, 6C), les moyens de commande incluant des moyens de circuit (82, 83) pour maintenir le synchronisme en rotation desdites première et seconde turbines à écoulement axial à plusieurs étages.

8. Dispositif comme revendiqué dans la revendication 4, la revendication 5 ou la revendication 6, comprenant de plus des moyens (8) pour commander des mouvements des première et seconde turbines à écoulement axial à plusieurs étages (6A, 6B, 6C), les moyens de commande incluant des moyens de circuit (82, 83) pour maintenir la vitesse de rotation de la première turbine à écoulement axial à plusieurs étages (6A) à un nombre entier de fois celui de la seconde turbine à écoulement axial à plusieurs étages (6B, 6C).
